# EUROPEAN PATENT APPLICATION

(11) **EP 4 779 337 A1**
(43) Date of publication of application: **22.07.2026**
(21) Application number: 24865430.3
(22) Date of filing: 10.09.2024
(51) Int. Cl.: G01R 31/389, G01R 31/382, G01R 31/385, G01R 31/392, H01M 10/48, H02J 7/00, H02J 7/04, H02J 7/10

(54) **BATTERY MONITORING DEVICE AND BATTERY MONITORING METHOD**

(30) Priority: 12.09.2023 JP 2023147340
(71) Applicant: Nuvoton Technology Corporation Japan, Nagaokakyo City, Kyoto 617-8520 (JP)
(72) Inventor: KATO, Takumi, Nagaokakyo City, Kyoto 617-8520 (JP); OKADA, Yu, Nagaokakyo City, Kyoto 617-8520 (JP); FUJII, Keiichi, Nagaokakyo City, Kyoto 617-8520 (JP); KOBAYASHI, Hitoshi, Nagaokakyo City, Kyoto 617-8520 (JP)
(74) Representative: Appelt, Christian W.
(86) International application number: PCT/JP2024/032339
(87) International publication number: WO 2025/057930

(57) **Abstract**

A battery monitoring device (201) includes: a signal generator that generates a control signal for controlling a first measurement circuit (1z) connected to a first assembled battery (1) and a second measurement circuit (2z) connected to a second assembled battery (2), the first assembled battery (1) and the second assembled battery (2) being obtained by dividing a plurality of batteries connected in series; and an impedance calculator (15) that calculates alternating current (AC) impedance of each of the plurality of batteries, based on (i) the measured current value of current flowing through the first measurement circuit (1z) and the measured voltage value of each battery included in the first assembled battery (1) and (ii) the measured current value of current flowing through the second measurement circuit (2z) and the measured voltage value of each battery included in the second assembled battery (2). The first measurement circuit (1z) includes a first switch. The second measurement circuit (2z) includes a second switch. The signal generator generates the control signal for turning on the first switch and the second switch in a mutually exclusive manner.

## Description

### [Technical Field]

The present disclosure relates to a battery monitoring device and a battery monitoring method.

### [Background Art]

In recent years, there has been a significant increase in applications utilizing secondary batteries, including environmentally friendly vehicles, such as electric vehicles (EVs), and storage batteries for a stable renewable energy supply. Lithium-ion batteries (LIBs) are often employed as secondary batteries because of their high energy density. It is known that the degradation of LIBs accelerates due to factors, such as overcharging, overdischarging, and temperature. In the worst case, this can lead to hazardous situations, including smoke and fire outbreak and even explosion. Accordingly, LIBs are typically integrated into a battery management system (BMS) and used under proper control.

Recently, consideration has been given to improving battery control accuracy by measuring the AC impedance of batteries to detect their degradation or internal temperature. For instance, Patent Literature (PTL) 1 discloses an AC impedance method for measuring the voltage and current while sweeping each battery in an assembled battery with an AC signal.

### [Citation List]

### [Patent Literature]

[PTL 1] International Publication No. WO2020/003841

### [Summary of Invention]

### [Technical Problem]

However, the method disclosed in PTL 1 has an issue with heat generation in the circuit used to measure the AC impedance of batteries.

In view of this, the present disclosure provides a battery monitoring device and a battery monitoring method that are capable of suppressing heat generation in a circuit used to measure the AC impedance of batteries.

### [Solution to Problem]

A battery monitoring device according to one aspect of the present disclosure includes: a signal generator that generates a control signal for controlling a first measurement circuit connected to a first assembled battery and a second measurement circuit connected to a second assembled battery, the first assembled battery and the second assembled battery being obtained by dividing a plurality of batteries connected in series; and an impedance calculator that calculates alternating current (AC) impedance of each of the plurality of batteries, based on (i) a first current value of current flowing through the first measurement circuit and a voltage value of each battery included in the first assembled battery and (ii) a second current value of current flowing through the second measurement circuit and a voltage value of each battery included in the second assembled battery, (i) the first current value and the voltage value and (ii) the second current value and the voltage value being measured at mutually different timings, in which the first measurement circuit includes a first switch connected in series with the first assembled battery, the second measurement circuit includes a second switch connected in series with the second assembled battery, and the signal generator generates the control signal for turning on the first switch and the second switch in a mutually exclusive manner.

A battery monitoring method according to another aspect of the present disclosure includes: generating a control signal for controlling a first measurement circuit connected to a first assembled battery and a second measurement circuit connected to a second assembled battery, the first assembled battery and the second assembled battery being obtained by dividing a plurality of batteries connected in series; and calculating alternating current (AC) impedance of each of the plurality of batteries, based on (i) a first current value of current flowing through the first measurement circuit and a voltage value of each battery included in the first assembled battery and (ii) a second current value of current flowing through the second measurement circuit and a voltage value of each battery included in the second assembled battery, (i) the first current value and the voltage value and (ii) the second current value and the voltage value being measured at mutually different timings, in which the first measurement circuit includes a first switch connected in series with the first assembled battery, the second measurement circuit includes a second switch connected in series with the second assembled battery, and in the generating of the control signal, the control signal for turning on the first switch and the second switch in a mutually exclusive manner is generated.

### [Advantageous Effects of Invention]

According to one aspect of the present disclosure, it is possible to embody, for example, a battery monitoring device capable of suppressing heat generation in a circuit used to measure the AC impedance of batteries.

### [Brief Description of Drawings]

[FIG. 1]

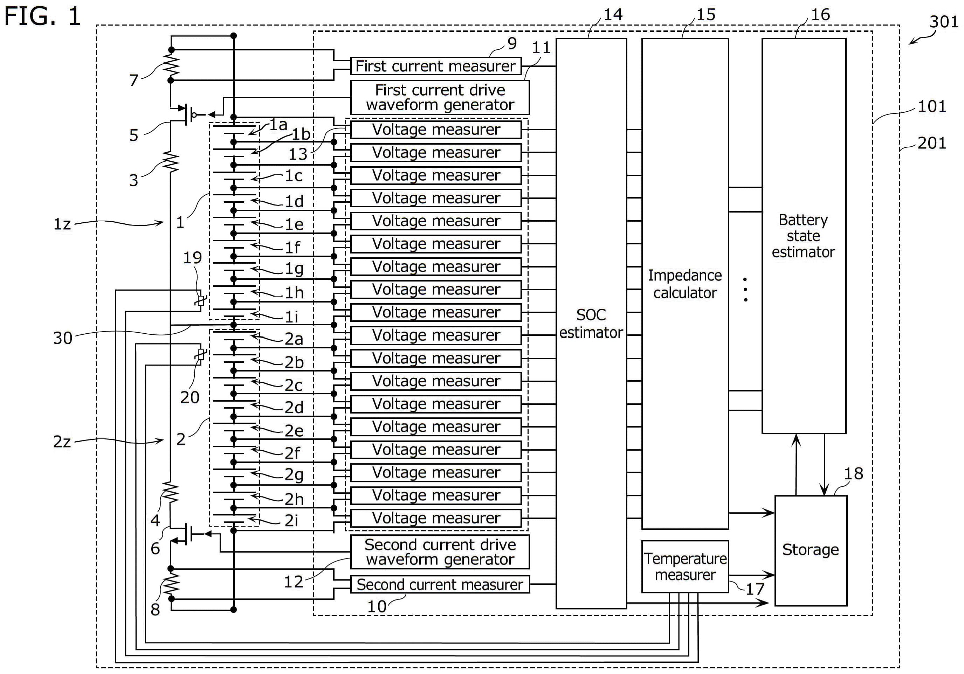

   FIG. 1 illustrates a configuration of a battery monitoring system according to Embodiment 1.
[FIG. 2]

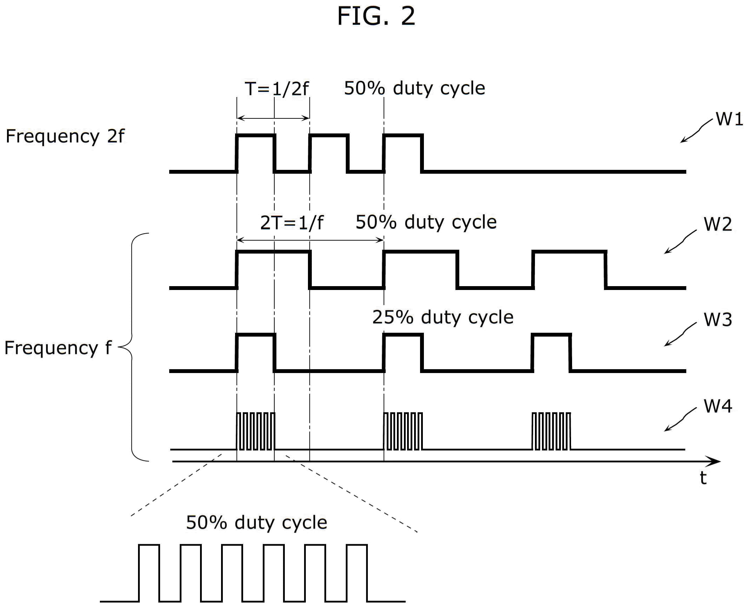

   FIG. 2 illustrates a voltage waveform of a control signal pulse applied to a transistor according to Embodiment 1.
[FIG. 3]

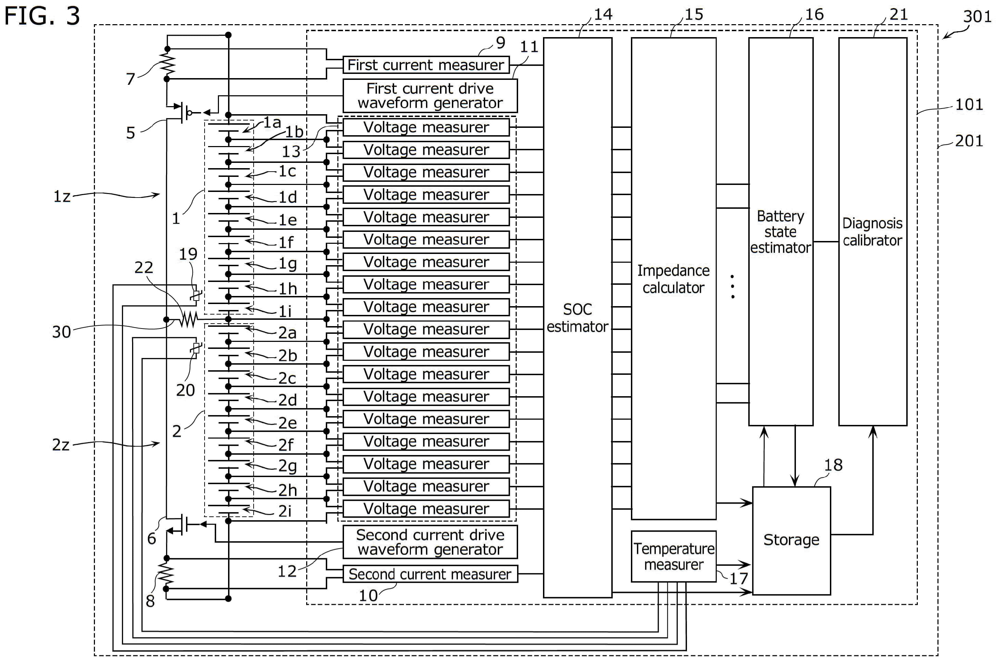

   FIG. 3 illustrates a configuration of a battery monitoring system according to Embodiment 2.
[FIG. 4]

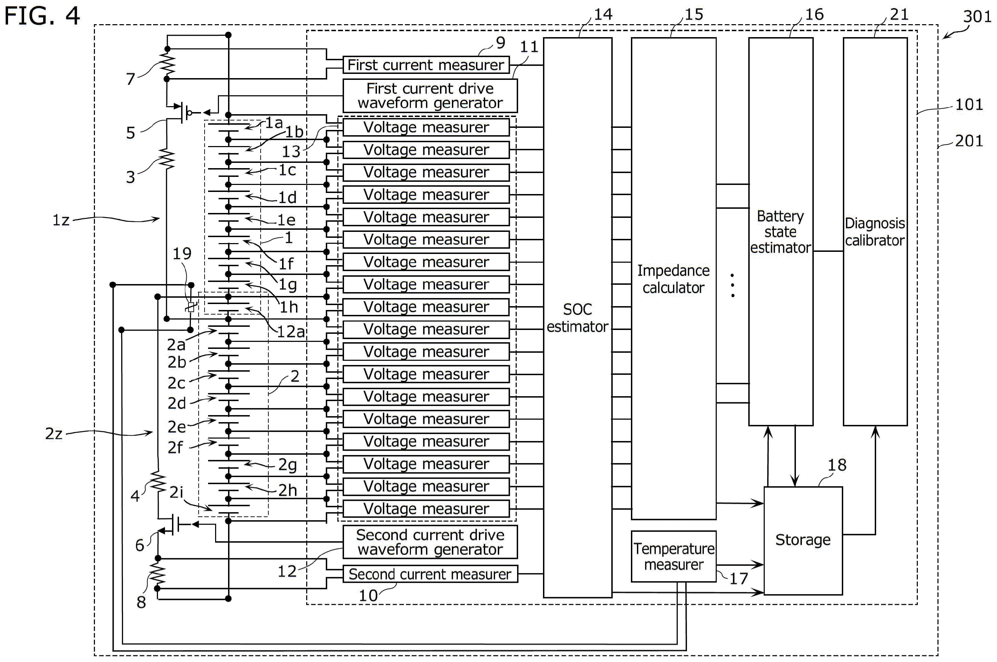

   FIG. 4 illustrates a configuration of a battery monitoring system according to Embodiment 3.
[FIG. 5]

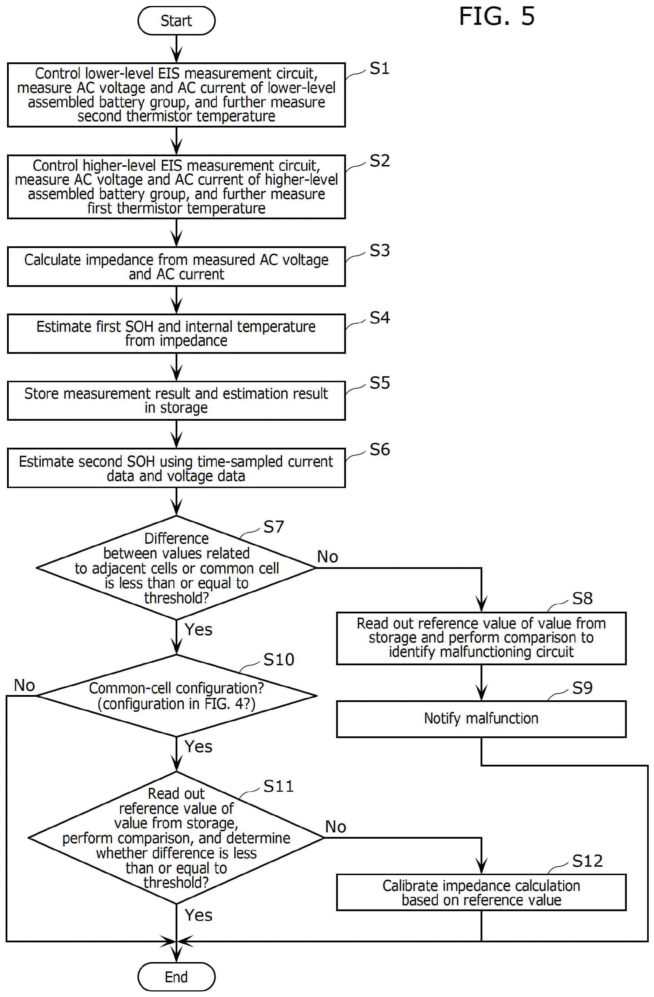

   FIG. 5 is a flowchart illustrating operation of the battery monitoring system according to each embodiment, related to malfunction diagnosis and calibration.
[FIG. 6]

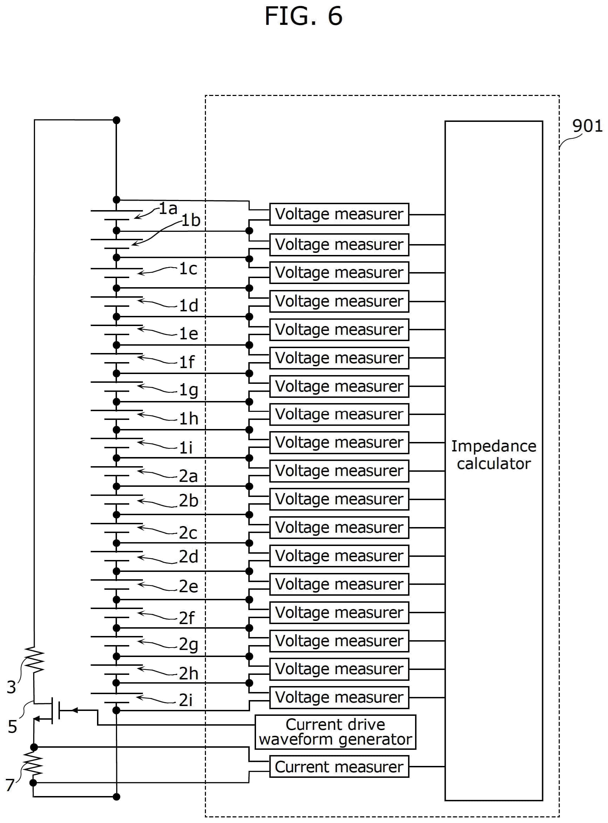

   FIG. 6 illustrates a configuration of a battery monitoring system in a conventional example.
[FIG. 7]

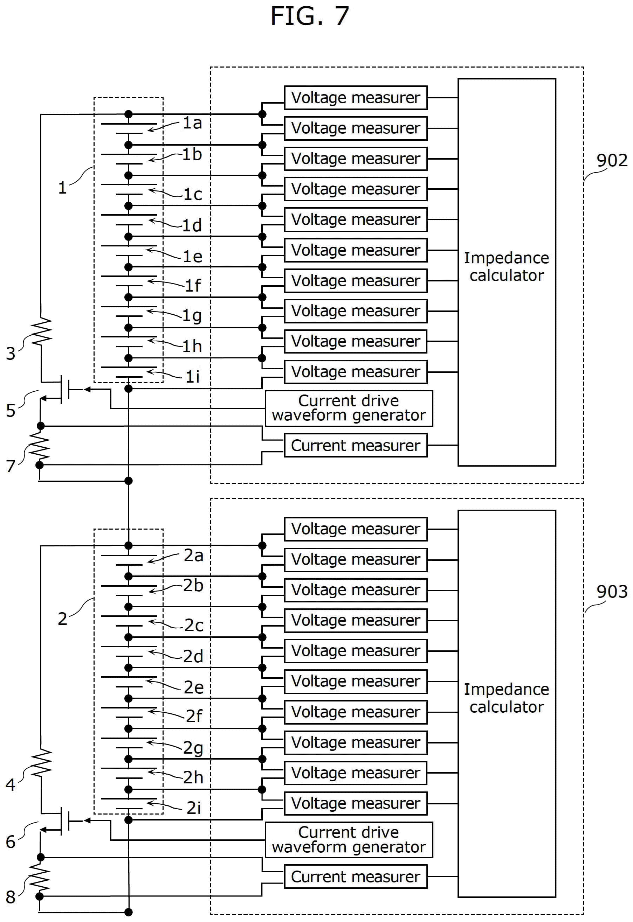

   FIG. 7 illustrates a configuration of a battery monitoring system in a comparison example.

### [Description of Embodiments]

### (Circumstances Leading to the Present Disclosure)

Prior to the explanation of the present disclosure, circumstances leading to the present disclosure are described with reference to FIGS. 6 and 7. FIG. 6 illustrates a configuration of a battery monitoring system in a conventional example. FIG. 7 illustrates a configuration of a battery monitoring system in a comparison example.

FIGS. 6 and 7 illustrate a battery monitoring system for an assembled battery in which 18 batteries including batteries 1a to 1i and batteries 2a to 2i are connected in series. The battery monitoring system illustrated in FIG. 6 includes first load resistor 3, first transistor 5, and first shunt resistor 7 as a circuit that measures the alternating current (AC) impedance of a battery, and includes, as an integrated circuit that measures impedance, impedance measurement integrated circuit 901 including a plurality of voltage measurers and an impedance calculator. That is, the battery monitoring system illustrated in FIG. 6 includes one integrated circuit. Moreover, the battery monitoring system illustrated in FIG. 7 includes first load resistor 3, first transistor 5, and first shunt resistor 7 as a circuit that measures the AC impedance of first assembled battery 1, includes, as an integrated circuit that measures impedance, impedance measurement integrated circuit 902 including a plurality of voltage measurers and an impedance calculator, includes second load resistor 4, second transistor 6, and second shunt resistor 8 as a circuit that measures the complex impedance of second assembled battery 2, and includes, as an integrated circuit that measures impedance, impedance measurement integrated circuit 903 including a plurality of voltage measurers and an impedance calculator. That is, the battery monitoring system illustrated in FIG. 7 includes two integrated circuits.

As described in the above Background section, although lithium-ion batteries are employed as secondary batteries in many cases, it is known that degradation of lithium-ion batteries is accelerated by overcharging, overdischarging, temperature, and so forth. Thus, lithium-ion batteries are generally integrated into a battery management system (BMS) and used under proper control.

For instance, PTL 1 proposes using an AC impedance method for measuring the voltage and current of a battery, to detect, for example, the degradation and internal temperature of the battery and improve the accuracy of battery control.

However, when the impedance measurement circuit proposed in PTL 1 measures the impedance of batteries connected in series (refer to, for example, FIG. 6), heat caused by the total voltage of the batteries and impedance measurement current is generated in first load resistor 3. Thus, it is necessary to dissipate the heat generated in the measurement, which requires adding heat-dissipation functionality, such as a fan, or mounting first load resistors 3 in parallel to disperse the load resistor heat generation. This leads to an increase in the circuit size.

Moreover, for a configuration as illustrated in FIG. 7, although it is possible to reduce the heat generated in first load resistor 3 and second load resistor 4, the impedance measurement circuits require as many wiring harnesses as the number of integrated circuits needed. Accordingly, the circuit size is increased in a scalable manner with an increase in the number of batteries in series. That is, in the comparison example illustrated in FIG. 7, it is difficult to achieve both the suppression of heat generation and the reduction in circuit size.

In light of the foregoing, the present inventors have conducted extensive studies about a battery monitoring device and a battery monitoring method that are capable of suppressing heat generation in a circuit that measures the AC impedance of batteries, and conceived the battery monitoring device and battery monitoring method described below. Moreover, the present inventors further conceived a battery monitoring device and a battery monitoring method that are capable of reducing the size of an AC impedance measurement circuit for an assembled battery including many batteries in series.

A battery monitoring device according to a first aspect of the present disclosure includes: a signal generator that generates a control signal for controlling a first measurement circuit connected to a first assembled battery and a second measurement circuit connected to a second assembled battery, the first assembled battery and the second assembled battery being obtained by dividing a plurality of batteries connected in series; and an impedance calculator that calculates alternating current (AC) impedance of each of the plurality of batteries, based on (i) a first current value of current flowing through the first measurement circuit and a voltage value of each battery included in the first assembled battery and (ii) a second current value of current flowing through the second measurement circuit and a voltage value of each battery included in the second assembled battery, (i) the first current value and the voltage value and (ii) the second current value and the voltage value being measured at mutually different timings, in which the first measurement circuit includes a first switch connected in series with the first assembled battery, the second measurement circuit includes a second switch connected in series with the second assembled battery, and the signal generator generates the control signal for turning on the first switch and the second switch in a mutually exclusive manner.

This allows the impedance measurement timings of the first assembled battery and the second assembled battery to be made independent of each other (made to differ from each other), which, in turn, disperses heat generation periods. Thus, it is possible to suppress heat generation in a load resistor. Accordingly, the battery monitoring device can suppress heat generation in a circuit that measures the AC impedance of the batteries.

Moreover, for instance, a battery monitoring device according to a second aspect is the battery monitoring device according to the first aspect, in which the first measurement circuit may include, as the first switch, a first transistor connected to the first assembled battery, the second measurement circuit may include, as the second switch, a second transistor connected to the second assembled battery, and the control signal may be a signal for causing the first transistor and the second transistor to operate in a time-division manner within respective independent periods.

Thus, use of the first transistor and the second transistor can easily make the impedance measurement timings independent of each other.

Moreover, for instance, a battery monitoring device according to a third aspect is the battery monitoring device according to the first or second aspect, in which a first control signal to be output to the first transistor and a second control signal to be output to the second transistor may be square-wave signals each controllable to any cycle, and the signal generator may set (i) a duty cycle of the first control signal corresponding to a cycle of the first control signal and (ii) a duty cycle of the second control signal corresponding to a cycle of the second control signal.

Thus, when the frequency of the control signal is varied (for example, swept), it is possible to suppress the change of heat generation in the load resistor due to the frequency. Moreover, for example, by setting the duty cycle to reduce the amount of heat generation, it is possible to reduce the amount of heat generation itself.

Moreover, for instance, a battery monitoring device according to a fourth aspect is the battery monitoring device according to any one of the first to third aspects, in which the first measurement circuit and the second measurement circuit may share a common part of a wiring harness.

This can reduce the number of wiring harnesses to be included in the first measurement circuit and the second measurement circuit. Thus, it is possible to achieve both the suppression of heat generation and the reduction of circuit size.

Moreover, for instance, a battery monitoring device according to a fifth aspect is the battery monitoring device according to the fourth aspect, in which the first measurement circuit may include a first load resistor for measuring the AC impedance and a first shunt resistor for current measurement, the first load resistor and the first shunt resistor being connected to the first assembled battery, the second measurement circuit may include a second load resistor for measuring the AC impedance and a second shunt resistor for current measurement, the second load resistor and the second shunt resistor being connected to the second assembled battery, and the common part of the wiring harness may be disposed to connect a negative terminal of the first assembled battery and a positive terminal of the second assembled battery to the first load resistor and the second load resistor.

Thus, it is possible to reduce the number of wiring harnesses for connecting the negative terminal of the first assembled battery and the positive terminal of the second assembled battery to the first load resistor and the second load resistor.

Moreover, for instance, a battery monitoring device according to a sixth aspect is the battery monitoring device according to the fourth aspect, in which the first measurement circuit may include the first assembled battery, a first load resistor for measuring the AC impedance, and a first shunt resistor for current measurement, the first load resistor and the first shunt resistor being connected to the first assembled battery, the second measurement circuit may include the second assembled battery, a second load resistor for measuring the AC impedance, and a second shunt resistor for current measurement, the second load resistor and the second shunt resistor being connected to the second assembled battery, and the first load resistor and the second load resistor may be provided in the common part of the wiring harness.

This can cause the first measurement circuit and the second measurement circuit to share a common load resistor, which can further reduce the circuit size.

Moreover, for instance, a battery monitoring device according to a seventh aspect is the battery monitoring device according to the fifth or sixth aspect that may further include an integrated circuit. The integrated circuit may include: a first current measurer that measures current flowing through the first shunt resistor; a first voltage measurer that measures voltage of each battery of the first assembled battery; a first impedance measurement calculator that calculates AC impedance of each battery of the first assembled battery, based on a current value measured by the first current measurer and a voltage value of each battery of the first assembled battery measured by the first voltage measurer; a second current measurer that measures current flowing through the second shunt resistor; a second voltage measurer that measures voltage of each battery of the second assembled battery; and a second impedance measurement calculator that calculates AC impedance of each battery of the second assembled battery, based on a current value measured by the second current measurer and a voltage value of each battery of the second assembled battery measured by the second voltage measurer.

Since the battery monitoring device can be implemented using a single integrated circuit including the functions, it is possible to reduce the circuit size compared to when two or more integrated circuits are included.

Moreover, for instance, a battery monitoring device according to an eighth aspect is the battery monitoring device according to any one of the fifth to seventh aspects, in which a most negative battery of the first assembled battery may be connected to a most positive battery of the second assembled battery, a positive terminal of a most positive battery of the first assembled battery may be connected to the first shunt resistor, the first shunt resistor may be connected to a first transistor that is the first switch, a negative terminal of a most negative battery of the second assembled battery may be connected to the second shunt resistor, and the second shunt resistor may be connected to a second transistor that is the second switch.

Thus, a transistor is disposed for each of the first measurement circuit and the second measurement circuit, which can easily cause the first measurement circuit and the second measurement circuit to share the common part of the wiring harness.

Moreover, for instance, a battery monitoring device according to a ninth aspect is the battery monitoring device according to any one of the first to eighth aspects, in which the plurality of batteries may include one or more batteries included in both the first assembled battery and the second assembled battery.

Sharing one or more common batteries makes it easier to detect malfunctions in the measurement circuits.

Moreover, for instance, a battery monitoring device according to a tenth aspect is the battery monitoring device according to any one of the first to ninth aspects, in which a most negative battery of the first assembled battery may be connected to a most positive battery of the second assembled battery, and the battery monitoring device may include: a calculator that, based on AC impedance of the most negative battery of the first assembled battery and AC impedance of the most positive battery of the second assembled battery, performs at least one of determination as to whether the first measurement circuit and the second measurement circuit are malfunctioning or calibration of the AC impedance of each of the plurality of batteries measured.

Since malfunctions in the measurement circuits can be detected using the AC impedance as a parameter, it is possible to improve the safety of the battery monitoring device.

Moreover, for instance, a battery monitoring device according to an eleventh aspect is the battery monitoring device according to any one of the first to tenth aspects that may include: a first calculator that estimates a first state of health (SOH) of any first battery included in the first assembled battery, based on AC impedance of the first battery, and estimates a second SOH of any second battery included in the second assembled battery, based on AC impedance of the second battery; and a second calculator that, based on the first SOH, the second SOH, a third SOH of the first battery, and a fourth SOH of the second battery, performs at least one of determination as to whether the first measurement circuit and the second measurement circuit are malfunctioning or calibration of the AC impedance of each of the plurality of batteries measured, the third SOH and the fourth SOH being estimated using a parameter other than AC impedance.

Since malfunctions in the measurement circuits can be detected using the state of health (SOH: capacity retention) as a parameter, it is possible to improve the safety of the battery monitoring device.

Moreover, for instance, a battery monitoring device according to a twelfth aspect is the battery monitoring device according to any one of the first to eleventh aspects, in which a most negative battery of the first assembled battery may be connected to a most positive battery of the second assembled battery. The battery monitoring device may include: a temperature measurer that measures temperature of the most negative battery of the first assembled battery and temperature of the most positive battery of the second assembled battery, based on (i) output of a first temperature sensor for measuring the temperature of the most negative battery and (ii) output of a second temperature sensor for measuring the temperature of the most positive battery; and a battery state estimator that, based on (i) internal temperature of the most negative battery of the first assembled battery estimated from AC impedance of the most negative battery and (ii) the temperature of the most positive battery and the temperature of the most negative battery measured by the temperature measurer, performs at least one of determination as to whether the first measurement circuit and the second measurement circuit are malfunctioning or calibration of the AC impedance of each of the plurality of batteries measured.

Since malfunctions in the measurement circuits can be detected using the temperature as a parameter, it is possible to improve the safety of the battery monitoring device.

Moreover, a battery monitoring method according to a thirteenth aspect includes: generating a control signal for controlling a first measurement circuit connected to a first assembled battery and a second measurement circuit connected to a second assembled battery, the first assembled battery and the second assembled battery being obtained by dividing a plurality of batteries connected in series; and calculating alternating current (AC) impedance of each of the plurality of batteries, based on (i) a first current value of current flowing through the first measurement circuit and a voltage value of each battery included in the first assembled battery and (ii) a second current value of current flowing through the second measurement circuit and a voltage value of each battery included in the second assembled battery, (i) the first current value and the voltage value and (ii) the second current value and the voltage value being measured at mutually different timings, in which the first measurement circuit includes a first switch connected in series with the first assembled battery, the second measurement circuit includes a second switch connected in series with the second assembled battery, and in the generating of the control signal, the control signal for turning on the first switch and the second switch in a mutually exclusive manner is generated.

Thus, the battery monitoring method has effects similar to those of the above battery monitoring device.

Hereinafter, embodiments in the present disclosure are described in detail with reference to the drawings.

It should be noted that each of the embodiments described below shows a specific example of the present disclosure. The numerical values, shapes, materials, elements, arrangement and connection of the elements, steps, order of steps, and so forth indicated in the embodiments described below are merely examples, and do not intend to limit the present disclosure. Moreover, among the elements described in the embodiments below, those not recited in the independent claims are described as optional elements.

Moreover, the figures are not necessarily precise illustrations. In the figures, substantially the same elements are assigned the same reference signs, and overlapping explanations are omitted or simplified.

Moreover, the term "connection" means electrical connection, and applies not only when two circuit elements are directly connected, but also when two circuit elements are indirectly connected with another circuit element interposed therebetween.

Moreover, in the specification, terms indicating relationships between elements, such as "same", and numerical values and ranges, should not be construed as limited to their strict interpretation. Rather, they are intended to encompass substantially equivalent ranges, including variations of, for example, a few percent (or approximately 10 percent).

Moreover, in the specification, ordinal numbers such as "first" and "second" are used for the purpose of distinguishing between similar elements to avoid confusion, and do not indicate the quantity or order of the elements unless explicitly stated otherwise.

### [Embodiment 1]

Hereinafter, a battery monitoring device according to Embodiment 1 is described with reference to FIGS. 1 and 2. FIG. 1 illustrates a configuration of battery monitoring system 301 according to Embodiment 1.

As illustrated in FIG. 1, battery monitoring system 301 is a system for monitoring (or controlling) an assembled battery in which secondary batteries, such as lithium-ion batteries, are connected in series. In Embodiment 1, battery monitoring system 301 is a system for monitoring first assembled battery 1 and second assembled battery 2.

Battery monitoring system 301 includes battery monitoring device 201 that includes first load resistor 3, first transistor 5, and first shunt resistor 7 which are connected in series with first assembled battery 1, second load resistor 4, second transistor 6, and second shunt resistor 8 which are connected in series with second assembled battery 2, first thermistor 19, second thermistor 20, and integrated circuit 101. Battery monitoring system 301 may further include an assembled battery (first assembled battery 1 and second assembled battery 2) to be monitored.

In Embodiment 1, the assembled battery is configured by connecting, in series, 18 batteries that include batteries 1a to 1i and batteries 2a to 2i. First assembled battery 1 includes one or more batteries, and in the example in FIG. 1, it includes nine batteries 1a to 1i connected in series. Second assembled battery 2 includes one or more batteries, and in the example in FIG. 1, it includes nine batteries 2a to 2i connected in series. First assembled battery 1 and second assembled battery 2 are connected in series to form a single assembled battery. Each of batteries 1a to 1i and batteries 2a to 2i is a secondary battery, such as a lithium-ion battery, configured to charge and discharge.

It should be noted that the number of batteries included in each of first assembled battery 1 and second assembled battery 2 is not particularly limited. For instance, the number of batteries included in first assembled battery 1 may differ from that of batteries included in second assembled battery 2. Moreover, there is no particular limit on the number of batteries included in battery monitoring system 301, and battery monitoring system 301 may include at least two batteries. Hereinafter, batteries 1a to 1i and batteries 2a to 2i may also be referred to as cells.

Moreover, although details are described later, battery monitoring system 301 is configured to measure, in a time-division manner, the voltage and current of first assembled battery 1 and those of second assembled battery 2.

First measurement circuit 1z is a circuit for measuring the alternating current (AC) impedance of each battery of first assembled battery 1, and includes first load resistor 3, first transistor 5, and first shunt resistor 7 which are connected in series with first assembled battery 1. When first transistor 5 is turned on, a loop circuit is formed by first load resistor 3, first transistor 5, first shunt resistor 7, and first assembled battery 1.

First load resistor 3 is connected to the negative terminal of first assembled battery 1 (the negative voltage terminal of battery 1i), and is a resistor for supplying a current to measure the impedance of each battery of first assembled battery 1.

First shunt resistor 7 is connected to the positive terminal of first assembled battery 1 (the positive voltage terminal of battery 1a), and is a current measurement resistor for measuring the current flowing through first measurement circuit 1z including first assembled battery 1. Both ends of first shunt resistor 7 are connected to first current measurer 9. Specifically, first shunt resistor 7 is a resistor for measuring current (pulse current) discharged by first assembled battery 1 after first transistor 5 is turned on.

First transistor 5 is connected between first load resistor 3 and first shunt resistor 7, and is switched between ON and OFF states by a control signal generated by first current drive waveform generator 11. First transistor 5 is controlled by the control signal to switch at a frequency for measuring the impedance. As a non-limiting example, first transistor 5 is a p-type transistor. First transistor 5 is an example of a switch (a first switch).

In first measurement circuit 1z configured as above, heat resulting from the total voltage of only batteries 1a to 1i out of batteries 1a to 1i and batteries 2a to 2i is generated in first load resistor 3. Since the voltage applied to first load resistor 3 can be decreased compared to the case in FIG. 6, it is possible to reduce the heat generated in first load resistor 3.

It should be noted that the arrangement order of first load resistor 3, first transistor 5, and first shunt resistor 7 is not limited to the order indicated in FIG. 1. First load resistor 3, first transistor 5, and first shunt resistor 7 may be connected in series between the positive and negative terminals of first assembled battery 1.

Second measurement circuit 2z is a circuit for measuring the AC impedance of each battery of second assembled battery 2, and includes second load resistor 4, second transistor 6, and second shunt resistor 8 which are connected in series with second assembled battery 2. When second transistor 6 is turned on, a loop circuit is formed by second load resistor 4, second transistor 6, second shunt resistor 8, and second assembled battery 2.

Second load resistor 4 is connected to the positive terminal of second assembled battery 2 (the positive voltage terminal of battery 2a), and is a resistor for supplying a current to measure the impedance of each battery of second assembled battery 2.

Second shunt resistor 8 is connected to the negative terminal of second assembled battery 2 (the negative voltage terminal of battery 2i), and is a current measurement resistor for measuring the current flowing through second measurement circuit 2z including second assembled battery 2. Both ends of second shunt resistor 8 are connected to second current measurer 10. Specifically, second shunt resistor 8 is a resistor for measuring current (pulse current) discharged by second assembled battery 2 after second transistor 6 is turned on.

Second transistor 6 is connected between second load resistor 4 and second shunt resistor 8, and is switched between ON and OFF states by a control signal generated by second current drive waveform generator 12. Second transistor 6 is controlled by the control signal to switch at a frequency for measuring the impedance. As a non-limiting example, second transistor 6 is an n-type transistor. Second transistor 6 is an example of a switch (a second switch).

In second measurement circuit 2z configured as above, heat resulting from the total voltage of only batteries 2a to 2i out of batteries 1a to 1i and batteries 2a to 2i is generated in second load resistor 4. Since the voltage applied to second load resistor 4 can be decreased compared to the case in FIG. 6, it is possible to reduce the heat generated in second load resistor 4.

It should be noted that the arrangement order of second load resistor 4, second transistor 6, and second shunt resistor 8 is not limited to the order indicated in FIG. 1. Second load resistor 4, second transistor 6, and second shunt resistor 8 may be connected in series between the positive and negative terminals of second assembled battery 2.

It should be noted that the first switch and the second switch are not limited to semiconductor switches, and may be switches other than semiconductor switches.

Here, first measurement circuit 1z and second measurement circuit 2z share a common part of wiring (for example, a part of a wiring harness). Battery monitoring system 301 includes common wiring harness 30 shared by first measurement circuit 1z and second measurement circuit 2z. Common wiring harness 30 is disposed to connect the negative terminal of first assembled battery 1 and the positive terminal of second assembled battery 2 to first load resistor 3 and second load resistor 4. This enables reduction in the measurement circuit size for the assembled batteries where many batteries are assembled in single integrated circuit 101. It should be noted that common wiring harness 30 need not necessarily be provided, and first measurement circuit 1z and second measurement circuit 2z may be formed using mutually different wirings.

First thermistor 19 is disposed close to first assembled battery 1, and is a temperature sensor for measuring the temperature of first assembled battery 1 (the surrounding temperature of first assembled battery 1) during the period in which the impedance of first assembled battery 1 is measured. In Embodiment 1, first thermistor 19 is disposed close to battery 1i (the most negative cell), which is the closest battery to second assembled battery 2 in first assembled battery 1, and measures the surrounding temperature of battery 1i. It should be noted that first thermistor 19 may be disposed at a voltage terminal of the most negative cell of first assembled battery 1.

Second thermistor 20 is disposed close to second assembled battery 2, and is a temperature sensor for measuring the temperature of second assembled battery 2 (the surrounding temperature of second assembled battery 2) during the period in which the impedance of second assembled battery 2 is measured. In Embodiment 1, second thermistor 20 is disposed close to battery 2a (the most positive cell), which is the closest battery to first assembled battery 1 in second assembled battery 2, and measures the surrounding temperature of battery 2a. It should be noted that second thermistor 20 may be disposed at a voltage terminal of the most positive cell of second assembled battery 2.

Since batteries 1i and 2a are adjacent batteries, first thermistor 19 and second thermistor 20 are disposed close to each other. Thus, when batteries 1i and 2a or elements of first measurement circuit 1z and second measurement circuit 2z are normal, it is assumed that the temperature measured by first thermistor 19 is close to that measured by second thermistor 20.

It should be noted that the temperature sensors included in battery monitoring system 301 are not limited to thermistors, but may be, for example, temperature sensors using other elements, such as thermocouples.

Integrated circuit 101 includes first current measurer 9, second current measurer 10, first current drive waveform generator 11, second current drive waveform generator 12, voltage measurer 13, state of charge (SOC) estimator 14, impedance calculator 15, battery state estimator 16, temperature measurer 17, and storage 18. Integrated circuit 101 includes, for example, a processor and memory. Examples of the memory include read-only memory (ROM) and random-access memory (RAM), and the memory is capable of storing a program to be executed by the processor. First current measurer 9, second current measurer 10, first current drive waveform generator 11, second current drive waveform generator 12, voltage measurer 13, SOC estimator 14, impedance calculator 15, battery state estimator 16, and temperature measurer 17 are implemented by, for example, the processor that executes the program stored in the memory. Moreover, for instance, the functions described above are achieved by single integrated circuit 101.

First current measurer 9 measures the current flowing through first measurement circuit 1z including first assembled battery 1. First current measurer 9 may include (i) an analog-to-digital converter (ADC) that converts an analog signal value corresponding to the current of first assembled battery 1 into a digital signal value and (ii) a calculator that performs calculation processing on the digital signal value, which is the output of the ADC, to calculate a current value. It should be noted that although first current measurer 9 is a resistance-detection-type current sensor using first shunt resistor 7, it may be a magnetic-field-detection-type current sensor.

Second current measurer 10 measures the current flowing through second measurement circuit 2z including second assembled battery 2. Second current measurer 10 may include (i) an ADC that converts an analog signal value corresponding to the current of second assembled battery 2 into a digital signal value and (ii) a calculator that performs calculation processing on the digital signal value, which is the output of the ADC, to calculate a current value. It should be noted that although second current measurer 10 is a resistance-detection-type current sensor using second shunt resistor 8, it may be a magnetic-field-detection-type current sensor.

First current drive waveform generator 11 generates a control signal for controlling ON and OFF of first transistor 5, and outputs the control signal to first transistor 5. The control signal is, for example, a square-wave signal controllable to any cycle, and is input into the gate electrode of first transistor 5. Moreover, the control signal contains frequency components.

Second current drive waveform generator 12 generates a control signal for controlling ON and OFF of second transistor 6, and outputs the control signal to second transistor 6. The control signal is, for example, a square-wave signal controllable to any cycle, and is input into the gate electrode of second transistor 6. Moreover, the control signal contains frequency components. The frequency components here may be, for example, the same as those of the control signal generated by first current drive waveform generator 11.

It should be noted that first current drive waveform generator 11 and second current drive waveform generator 12 generate a control signal to turn only one of first transistor 5 or second transistor 6 ON. The control signal is a signal for causing first transistor 5 and second transistor 6 to operate in a time-division manner during respective independent periods. In other words, first current drive waveform generator 11 and second current drive waveform generator 12 generate a control signal for turning on first transistor 5 and second transistor 6 in a mutually exclusive manner. Thus, the control signal enables control that prevents the period during which first transistor 5 is in an ON state from temporally overlapping the period during which second transistor 6 is in an ON state.

Thus, current and voltage measurements for first assembled battery 1 and second assembled battery 2 are performed in a time-division manner in separate periods. Thus, by controlling ON and OFF of first transistor 5 and second transistor 6 in a time-division manner, the impedance measurement timing for first assembled battery 1 and that for second assembled battery 2 can be made independent of each other (made to differ from each other). As a result, heat generation periods can be dispersed, which enables suppression of heat generation in the load resistors. It should be noted that first current drive waveform generator 11 and second current drive waveform generator 12 are examples of signal generators.

It should be noted that the ON-period of first transistor 5 and the ON-period of second transistor 6 may only partially overlap, and are not limited to the case of no temporal overlap.

FIG. 2 illustrates a voltage waveform of a control signal pulse applied to a transistor according to Embodiment 1. FIG. 2 exemplifies voltage waveforms of four control signals (control signals w1 to w4) generated by first current drive waveform generator 11 and second current drive waveform generator 12.

Control signal w1 is frequency 2f, and indicates a voltage waveform for a duty cycle of 50%.

Control signal w2 is frequency f, and indicates a voltage waveform for a duty cycle of 50%.

When first transistor 5 is turned on by control signal w1, a pulse current with frequency 2f is discharged by first assembled battery 1 during the ON-period. Thus, first load resistor 3 generates heat. When the control signal is switched from control signal w1 to control signal w2, that is, the frequency of the control signal is changed from frequency 2f to frequency f, and the duty cycle is maintained at 50%, the amount of heat generated by first load resistor 3 doubles.

The duty cycle may be adjusted according to the frequencies to suppress the difference in the heat generation amount due to the difference in the frequencies of control signals. By doing so, even if the frequency of the control signal is changed, the heat generation amount can be brought closer to a constant level while maintaining the ON-period constant. For instance, when the frequency of the control signal is changed from frequency 2f to frequency f, control signal w3 where the duty cycle is reduced from 50% to 25% may be used. Moreover, control signal w4 with a duty cycle of 50% within the ON period pulse may be used to further suppress the heat generation amount.

First current drive waveform generator 11 sets the duty cycle of a first control signal corresponding to the cycle of the first control signal. Second current drive waveform generator 12 sets the duty cycle of a second control signal corresponding to the cycle of the second control signal. First current drive waveform generator 11 and second current drive waveform generator 12 set the duty cycle of the control in the frequency range from f to 2f, inclusive such that the difference between (i) the heat generation amount at a reference frequency set in a predetermined frequency band (for example, at least frequency f and at most 2f) and (ii) the heat generation amount at another frequency that is at least frequency f and at most frequency 2f is less than or equal to a predetermined value. For instance, first current drive waveform generator 11 and second current drive waveform generator 12 may decrease the duty cycle with a decrease in the frequency, and increase the duty cycle with an increase in the frequency. For instance, a table associating frequencies with duty cycles is stored in storage 18, and first current drive waveform generator 11 and second current drive waveform generator 12 may change the duty cycle according to the frequencies, using the table.

The reference frequency may be a frequency higher than or equal to a predetermined level (for example, the highest frequency) within the frequency band. When the frequency band is from frequency f to frequency 2f, inclusive, the reference frequency may be frequency 2f. For instance, assuming that the duty ratio is the same within the frequency band, the reference frequency may be a frequency at which the heat generation amount is less than or equal to a predetermined level (for example, the smallest).

It should be noted that for instance, during the period in which the control signal is applied to first transistor 5, the OFF control signal (a control signal with a constant voltage) may be applied to second transistor 6.

The description returns to FIG. 1. Voltage measurers 13 are provided in one-to-one correspondence with the batteries, and measure the voltage of a battery connected to that voltage measurer. Voltage measurer 13 may include (i) an ADC that converts an analog signal value corresponding to the voltage of the battery into a digital signal value and (ii) a calculator that performs calculation processing on the digital signal value, which is the output of the ADC, to calculate a voltage value.

SOC estimator 14 measures the SOC of an assembled battery. For instance, SOC estimator 14 may obtain the current and voltage of the assembled battery or each of batteries 1a to 2i included in the assembled battery, and calculate the SOC by the Coulomb counting method or from the state of charge-open circuit voltage (SOC-OCV) curve.

Impedance calculator 15 calculates the AC impedance of each of batteries 1a to 1i and batteries 2a to 2i from AC voltages and AC currents obtained by measuring first assembled battery 1 and second assembled battery 2. Impedance calculator 15 measures current I1 flowing through first shunt resistor 7 and voltage Vn1 of each battery of first assembled battery 1, current I1 and voltage Vn1 being obtained by applying a control signal containing frequency components to the control terminal of first transistor 5. Moreover, impedance calculator 15 measures current I2 flowing through second shunt resistor 8 and voltage Vn2 of each battery of second assembled battery 2, current I2 and voltage Vn2 being obtained by applying a control signal containing frequency components to the control terminal of second transistor 6.

Then, impedance calculator 15 converts measured current I1 and current I2 into a complex current and measured voltage Vn1 and voltage Vn2 into a complex voltage. After that, impedance calculator 15 performs an averaging process of the complex current and an averaging process of the complex voltage. Impedance calculator 15 calculates the AC impedance of each battery by dividing the complex voltage which has undergone the averaging process, by the complex current which has undergone the averaging process. Each AC impedance is a complex number (complex impedance), and has real component Re and imaginary component Im. It should be noted that hereinafter, AC impedance may be simply referred to as impedance.

Battery state estimator 16 estimates, from the result of calculation by impedance calculator 15, at least one of a state of health (SOH: capacity retention) indicating a degradation state of a battery or the internal temperature of the battery.

When a first correspondence between AC impedance and the full charge capacity of a battery is obtained in advance, battery state estimator 16 may estimate the current full charge capacity of the battery from the first correspondence and the current AC impedance, and calculate the SOH (%) by dividing the estimated current full charge capacity by the initial full charge capacity, and multiplying the result of the division by 100. The initial full charge capacity and the first correspondence may be stored in storage 18. Moreover, the first correspondence may be, for example, a table associating AC impedance with the full charge capacity of the battery.

When a second correspondence between AC impedance and the internal temperature of a battery is obtained in advance, battery state estimator 16 may estimate the current internal temperature of the battery from the second correspondence and the current AC impedance. The second correspondence may be stored in storage 18. Moreover, the second correspondence may be, for example, a table associating the AC impedance with the internal temperature of the battery.

It should be noted that a method for estimating the SOH and internal temperature is not limited to above method, and any known methods may be used.

Temperature measurer 17 measures the temperature of each assembled battery. Temperature measurer 17 is connected to first thermistor 19 close to first assembled battery 1 and connected to second thermistor 20 close to second assembled battery 2, and measures the surrounding temperature of first thermistor 19 and that of second thermistor 20. In Embodiment 1, temperature measurer 17 measures the temperature in the vicinity of battery 1i and that in the vicinity of battery 2a.

Storage 18 is a storage device storing various information items and various programs used for estimating a battery state. Storage 18 is implemented as, for example, a hard disk drive (HDD) or semiconductor memory.

It should be noted that integrated circuit 101 may include a diagnosis calibrator (for example, diagnosis calibrator 21 illustrated in FIG. 3, which is described later) that performs malfunction diagnosis and impedance calibration.

### [Embodiment 2]

A configuration of a battery monitoring device according to Embodiment 2 is described with reference to FIG. 3. FIG. 3 illustrates a configuration of battery monitoring system 301 according to Embodiment 2. Battery monitoring system 301 according to Embodiment 2 differs from battery monitoring system 301 according to Embodiment 1 mainly in the following point: a load resistor (third load resistor 22) is a resistor common to first measurement circuit 1z and second measurement circuit 2z. It should be noted that the following description focuses on differences from Embodiment 1, and explanations of the same or similar parts as in Embodiment 1 are omitted or simplified. Moreover, for convenience, the same or similar elements as in Embodiment 1 are described using the reference signs used in Embodiment 1.

As illustrated in FIG. 3, battery monitoring system 301 includes third load resistor 22 instead of first load resistor 3 and second load resistor 4 illustrated in FIG. 1, and further includes diagnosis calibrator 21.

Third load resistor 22 is provided in common wiring harness 30. One end of third load resistor 22 is connected to the negative terminal of first assembled battery 1 and the positive terminal of second assembled battery 2, and the other end of third load resistor 22 is connected to first transistor 5 and second transistor 6. This can reduce the number of load resistors, which enables reduction in the measurement circuit size.

Diagnosis calibrator 21 diagnoses (determines), based on the AC impedance, whether a measurement circuit (e.g., an element of a measurement circuit) is malfunctioning, and calibrates the impedance. Diagnosis calibrator 21 is described later with reference to FIG. 5.

It should be noted that the number of batteries included in first assembled battery 1 is the same as that of batteries included in second assembled battery 2. However, the above numbers may be different if the measurement accuracy meets the intended accuracy.

### [Embodiment 3]

A configuration of a battery monitoring device according to Embodiment 3 is described with reference to FIG. 4. FIG. 4 illustrates a configuration of battery monitoring system 301 according to Embodiment 3. Battery monitoring system 301 according to Embodiment 3 differs from battery monitoring system 301 according to Embodiment 1 in the following point: battery 12a is included in each of first assembled battery 1 and second assembled battery 2. It should be noted that the following description focuses on differences from Embodiment 1, and explanations of the same or similar parts as in Embodiment 1 are omitted or simplified. Moreover, for convenience, the same or similar elements as in Embodiment 1 are described using the reference signs used in Embodiment 1.

As illustrated in FIG. 4, in battery monitoring system 301 according to Embodiment 3, to make the most negative cell of first assembled battery 1 and the most positive cell of second assembled battery 2 the same cell, first load resistor 3 is connected to the negative terminal of the same cell, and second load resistor 4 is connected to the positive terminal of the same cell. First assembled battery 1 includes nine batteries including batteries 1a to 1h and common battery 12a, and second assembled battery 2 includes 10 batteries including batteries 2a to 2i and common battery 12a. It should be noted that the number of batteries is not limited to the above, and first assembled battery 1 and second assembled battery 2 may have the same number of batteries.

The voltage of battery 12a is measured both when first assembled battery 1 is measured and when second assembled battery 2 is measured. The measurement result (voltage value) of the voltage of battery 12a at the time of measurement of first assembled battery 1 is expected to be the same as the measurement result (voltage value) of the voltage of battery 12a at the time of measurement of second assembled battery 2. If the two voltage values are different, it is possible to determine whether any element of the measurement circuits (for example, at least one of first load resistor 3, second load resistor 4, first transistor 5, second transistor 6, first shunt resistor 7, or second shunt resistor 8) is malfunctioning. That is, battery monitoring system 301 according to Embodiment 3 can perform malfunction diagnosis for the measurement circuits.

It should be noted that the determination may be made using, for example, the current and previous voltage values of battery 12a in first assembled battery 1 or second assembled battery 2. That is, it may be determined whether aging degradation of battery 12a is present.

First thermistor 19 is disposed in the vicinity of common battery 12a.

It should be noted that the number of common batteries of first assembled battery 1 and second assembled battery 2 is not limited to one, and may be two or more.

### (Operation Example)

Then, operation related to malfunction diagnosis and calibration performed by battery monitoring system 301 described in each of the above embodiments is described with reference to FIG. 5. FIG. 5 is a flowchart illustrating operation (a battery monitoring method) related to malfunction diagnosis and calibration in battery monitoring system 301 according to each embodiment.

As illustrated in FIG. 5, first, battery monitoring device 201 controls a lower-level electrochemical impedance spectroscopy (EIS) measurement circuit (second measurement circuit 2z), measures the AC voltage and AC current of a lower-level assembled battery group (second assembled battery 2), and further measures a second thermistor temperature (S1). The second thermistor temperature is temperature measured using second thermistor 20. Battery monitoring device 201 turns off first transistor 5 and turns on second transistor 6 to measure the AC voltage and AC current of second assembled battery 2. It should be noted that to turn on second transistor 6 means to switch between ON and OFF of second transistor 6 at a frequency for measuring impedance, using a control signal as illustrated in FIG. 2.

Next, after step S1, battery monitoring device 201 controls a higher-level EIS measurement circuit (first measurement circuit 1z), measures the AC voltage and AC current of a higher-level assembled battery group (first assembled battery 1), and further measures a first thermistor temperature (S2). The first thermistor temperature is temperature measured using first thermistor 19. Battery monitoring device 201 turns on first transistor 5 and turns off second transistor 6 to measure the AC voltage and AC current of first assembled battery 1.

Thus, measurement of first measurement circuit 1z and that of second measurement circuit 2z are performed at mutually different timings in a time-division manner.

Then, impedance calculator 15 calculates impedance (AC impedance) from the measured AC voltage and AC current (S3).

Then, battery state estimator 16 estimates a first SOH and internal temperature from the impedance calculated by impedance calculator 15 (S4).

Then, battery state estimator 16 stores the measurement results and estimation results in storage 18 (S5). Thus, the measured values measured in steps S1 and S2 and the estimated values estimated in step S4 are stored in storage 18.

Then, battery state estimator 16 estimates a second SOH using time-sampled current data and voltage data (S6). Under the condition of constant frequency, battery state estimator 16 estimates the second SOH, based on the current and voltage time response when a battery is discharged.

It should be noted that in the time sampling, time sampling of the voltage of each battery in first assembled battery 1 and second assembled battery 2 is performed using voltage measurer 13, time sampling of current is performed using first current measurer 9, and time sampling of current is performed using second current measurer 10. Moreover, measurement (time sampling) of first measurement circuit 1z and measurement (time sampling) of second measurement circuit 2z may be performed at mutually different timings in a time-division manner.

Then, battery state estimator 16 determines whether the difference between values (e.g., estimated values) related to adjacent cells or a common cell is less than or equal to a threshold (S7). The values related to the adjacent cells or common cell may be the measured impedance itself or values indicating a battery state, such as an SOH or internal temperature. Hereinafter, an example in which the values indicate a battery state is described.

For example, for the configuration illustrated in FIG. 1 or FIG. 3, battery state estimator 16 determines whether the difference between the SOHs or the internal temperatures of adjacent batteries (e.g., batteries 1i and 2a) is less than or equal to the threshold. When the SOH is used, for instance, battery state estimator 16 performs at least one of a comparison between the first SOH of battery 1i and the first SOH of battery 2a, which were estimated in step S4, or a comparison between the second SOH of battery 1i and the second SOH of battery 2a, which were estimated in step S6. Then, battery state estimator 16 determines whether the difference between the SOHs is less than or equal to the threshold.

Moreover, for example, for the configuration illustrated in FIG. 4, battery state estimator 16 determines whether an SOH difference or an internal temperature difference in the common cell (e.g., battery 12a) is less than or equal to the threshold. When the SOH is used, for instance, battery state estimator 16 performs at least one of a comparison between the first SOH of battery 12a at the time of measurement of first measurement circuit 1z and the first SOH of battery 12a at the time of measurement of second measurement circuit 2z or a comparison between the second SOH of battery 12a at the time of measurement of first measurement circuit 1z and the second SOH of battery 12a at the time of measurement of second measurement circuit 2z. Then, battery state estimator 16 determines whether the SOH difference is less than or equal to the threshold.

If any element included in first measurement circuit 1z and second measurement circuit 2z is malfunctioning, the difference in step S7 exceeds the threshold. It should be noted that whether there is a malfunction is identified at this time point. However, if there is a malfunction, it is not possible to identify which measurement circuit includes a malfunctioning element. The threshold is preset and stored in storage 18.

It should be noted that the determination in step S7 may be performed as to whether the difference between the first SOH of a battery estimated in step S4 (in first measurement circuit 1z, for example, battery 1i) and the second SOH of the same battery estimated in step S6 is less than or equal to the threshold. In this case, the determination is performed in each of first measurement circuit 1z and second measurement circuit 2z.

When the difference between the values is not less than or equal to the threshold, that is, when the difference between the two estimated values is greater than the threshold (No in S7), there is a possibility that one of the elements of the measurement circuits is malfunctioning. Thus, diagnosis calibrator 21 reads out the reference value of a value from storage 18, performs comparisons with the reference value, and identifies a malfunctioning circuit (S8). To identify which of first measurement circuit 1z and second measurement circuit 2z includes a malfunctioning element, diagnosis calibrator 21 reads out, from storage 18, the reference value of an SOH, which is an example of the value, and identifies, based on the reference value and the SOHs of adjacent batteries, that a measurement circuit including a battery having a greater difference from the reference value is a malfunctioning circuit.

Then, diagnosis calibrator 21 performs malfunction notification (S9). Diagnosis calibrator 21 transmits information indicating the identified malfunctioning circuit to a terminal device of a user (for example, a manager of the assembled batteries).

Moreover, when the difference between the values is less than or equal to the threshold, that is, when the difference between the two estimated values is small (Yes in S7), diagnosis calibrator 21 further determines whether the measurement circuits have a common-cell configuration (S10). As illustrated in FIG. 4, the common-cell configuration means a configuration in which the two measurement circuits share a common cell (battery 12a). Information indicating whether the configuration is the common-cell configuration may be stored in, for example, storage 18. It should be noted that a case where the difference between the values is less than or equal to the threshold means that the measurement circuits are not malfunctioning.

When determining that the configuration is the common-cell configuration (Yes in S10), diagnosis calibrator 21 further reads out the reference value of the value from storage 18, performs a comparison with the reference value, and determines whether the difference from the reference value is less than or equal to the threshold (S11). Diagnosis calibrator 21 compares the SOH or the internal temperature of the common cell (battery 12a in the example in FIG. 4) with the reference value of that value, and determines whether the difference is less than or equal to the threshold. The threshold here may be the same as, or different from, the threshold in step S7.

When determining that the difference is less than or equal to the threshold in the common-cell configuration (Yes in S11), or when the configuration is not the common-cell configuration (No in S10), diagnosis calibrator 21 ends the processing.

Moreover, when determining that the difference is not less than or equal to the threshold in the common-cell configuration, that is, when the difference between the estimated value and the reference value is greater than the threshold (No in S11), diagnosis calibrator 21 calibrates impedance calculation based on the reference value (S12). Diagnosis calibrator 21 determines that the measurement accuracy of impedance has decreased due to external factors (such as the effects of the magnetic field of an external circuit), and calibrates the impedance calculated in step S3. Here, to calibrate means to bring the impedance calculated in step S3 closer to a true value, based on the reference value.

Diagnosis calibrator 21 calibrates the impedance stored in storage 18, based on the reference value, and stores the calibrated impedance in storage 18. Diagnosis calibrator 21 may replace the impedance calculated in step S3 with the reference value, replace it with the statistical value of the impedance obtained in previous measurements, or multiply the impedance calculated in step S3 with a coefficient based on the reference value. Although the statistical value is a mean value, it may be, for example, a medium value.

### [Other Embodiments]

Although the battery monitoring device and so forth according to one or more aspects are described above based on the embodiments, the present disclosure is not limited to the embodiments. The present disclosure may encompass embodiments obtained by adding various modifications envisioned by those skilled in the art to the above embodiments, as well as embodiments created by combining elements from different embodiments, provided that such embodiments remain within the scope of the present disclosure.

For example, battery monitoring device 201 and battery monitoring system 301 according to the present disclosure can be used as a battery monitoring device and a BMS that monitor a battery, such as an assembled battery in which cells, such as lithium-ion batteries, are connected in series. Specifically, battery monitoring device 201 and battery monitoring system 301 can be used as a small battery monitoring device that can measure the impedance of a battery, and can be used as, for example, a battery monitoring device that monitors a storage battery provided in an environmentally friendly vehicle, such as an electric vehicle (EV), as well as a storage battery for a stable renewable energy supply.

Moreover, an example of dividing a plurality of batteries into two assembled batteries is described in the embodiments described above. However, the number of divided assembled batteries is not limited to two and may be three or more. In this case, the impedance of each of the three or more assembled batteries is measured at mutually different timings.

Moreover, in the embodiments described above, each element may be implemented as dedicated hardware or by executing a software program suitable for the element. Each element may be implemented by a program executer, such as a CPU or a processor, reading out and executing the software program stored in a recording medium, such as a hardware disk or semiconductor memory.

Moreover, the order of the steps in the flowchart is presented for illustrative purposes to explain the present disclosure in detail, and the steps may be performed in a different order. Moreover, some of the steps may be performed with other steps simultaneously (in parallel), or some of the steps need not be performed.

Moreover, the division of functional blocks in a block diagram is merely an example. A plurality of functional blocks may be formed as a single functional block, a single functional block may be divided into a plurality of functional blocks, or some functions may be transferred to other functional blocks. Moreover, functions of a plurality of functional blocks having similar functions may be processed in parallel or in a time-division manner by a single piece of hardware or software.

Moreover, battery monitoring device 201 according to the above embodiments may be implemented as a single device or using a plurality of devices. If battery monitoring device 201 is implemented using a plurality of devices, the elements of battery monitoring device 201 may be allocated to the plurality of devices in any way. When battery monitoring device 201 is implemented using a plurality of devices, the communication method between the plurality of devices is not particularly limited and may be wireless communication or wired communication. Moreover, wireless communication and wired communication may be combined as communication between devices.

Moreover, each element described in the above embodiments may be implemented as software, or may typically be implemented as an LSI, which is an integrated circuit. Each element may be integrated into an individual chip, or some or all of the elements may be integrated into a single chip. Here, it is referred to as an LSI, but it may also be referred to as an IC, system LSI, super LSI, or ultra LSI depending on the degree of integration. Moreover, the method of integrated-circuit implementation is not limited to an LSI, and may be implemented as a dedicated circuit (a general-purpose circuit that executes a dedicated program) or a general-purpose processor. A field programmable gate array (FPGA) that can be programmed after LSI manufacturing, or a reconfigurable processor that can reconfigure the connection or settings of circuit cells inside the LSI may also be used. Furthermore, if a technology for integrated-circuit implementation that can replace an LSI emerges due to advancements in semiconductor or derivative technologies, it is natural to integrate the elements using the technology.

A system LSI is a super multifunctional LSI manufactured by integrating processors into one chip, and specifically a computer system including a microprocessor, ROM, and RAM. A computer program is stored in the ROM. The system LSI achieves its function by the microprocessor operating according to the computer program.

Moreover, one aspect of the present disclosure may be a computer program for causing a computer to perform characteristic steps included in the battery monitoring method illustrated in FIG. 5.

Moreover, for example, the program may be a program for causing a computer to execute. Moreover, one aspect of the present disclosure may be a computer-readable non-transitory recording medium having recorded thereon such a program. For example, such a program may be recorded on a recording medium and distributed or circulated. For example, by installing a distributed program on a device including another processor and causing that processor to execute the program, it is possible to cause the device to perform each of the above processes.

### [Industrial Applicability]

The present disclosure is useful for, for example, a battery monitoring device that monitors a battery such as an assembled battery.

### [Reference Signs List]

1 first assembled battery
1a, 1b, 1c, 1d, 1e, 1f, 1g, 1h, 1i, 2a, 2b, 2c, 2d, 2e, 2f, 2g, 2h, 2i, 12a battery
1z first measurement circuit
2 second assembled battery
2z second measurement circuit
3 first load resistor
4 second load resistor
5 first transistor
6 second transistor
7 first shunt resistor
8 second shunt resistor
9 first current measurer
10 second current measurer
11 first current drive waveform generator
12 second current drive waveform generator
13 voltage measurer
14 SOC estimator
15 impedance calculator
16 battery state estimator
17 temperature measurer
18 storage
19 first thermistor (first temperature sensor)
20 second thermistor (second temperature sensor)
21 diagnosis calibrator
22 third load resistor
30 common wiring harness
101 integrated circuit
201 battery monitoring device
301 battery monitoring system
901, 902, 903 impedance measurement integrated circuit
w1, w2, w3, w4 control signal

## Claims

1. A battery monitoring device comprising:
a signal generator that generates a control signal for controlling a first measurement circuit connected to a first assembled battery and a second measurement circuit connected to a second assembled battery, the first assembled battery and the second assembled battery being obtained by dividing a plurality of batteries connected in series; and
an impedance calculator that calculates alternating current (AC) impedance of each of the plurality of batteries, based on (i) a first current value of current flowing through the first measurement circuit and a voltage value of each battery included in the first assembled battery and (ii) a second current value of current flowing through the second measurement circuit and a voltage value of each battery included in the second assembled battery, (i) the first current value and the voltage value and (ii) the second current value and the voltage value being measured at mutually different timings, wherein
the first measurement circuit includes a first switch connected in series with the first assembled battery,
the second measurement circuit includes a second switch connected in series with the second assembled battery, and
the signal generator generates the control signal for turning on the first switch and the second switch in a mutually exclusive manner.

2. The battery monitoring device according to claim 1, wherein
the first measurement circuit includes, as the first switch, a first transistor connected to the first assembled battery,
the second measurement circuit includes, as the second switch, a second transistor connected to the second assembled battery, and
the control signal is a signal for causing the first transistor and the second transistor to operate in a time-division manner within respective independent periods.

3. The battery monitoring device according to claim 2, wherein
a first control signal to be output to the first transistor and a second control signal to be output to the second transistor are square-wave signals each controllable to any cycle, and
the signal generator sets (i) a duty cycle of the first control signal corresponding to a cycle of the first control signal and (ii) a duty cycle of the second control signal corresponding to a cycle of the second control signal.

4. The battery monitoring device according to claim 1, wherein
the first measurement circuit and the second measurement circuit share a common part of a wiring harness.

5. The battery monitoring device according to claim 4, wherein
the first measurement circuit includes a first load resistor for measuring the AC impedance and a first shunt resistor for current measurement, the first load resistor and the first shunt resistor being connected to the first assembled battery,
the second measurement circuit includes a second load resistor for measuring the AC impedance and a second shunt resistor for current measurement, the second load resistor and the second shunt resistor being connected to the second assembled battery, and
the common part of the wiring harness is disposed to connect a negative terminal of the first assembled battery and a positive terminal of the second assembled battery to the first load resistor and the second load resistor.

6. The battery monitoring device according to claim 4, wherein
the first measurement circuit includes the first assembled battery, a first load resistor for measuring the AC impedance, and a first shunt resistor for current measurement, the first load resistor and the first shunt resistor being connected to the first assembled battery,
the second measurement circuit includes the second assembled battery, a second load resistor for measuring the AC impedance, and a second shunt resistor for current measurement, the second load resistor and the second shunt resistor being connected to the second assembled battery, and
the first load resistor and the second load resistor are provided in the common part of the wiring harness.

7. The battery monitoring device according to claim 5 or 6, further comprising:
an integrated circuit, wherein
the integrated circuit includes:
a first current measurer that measures current flowing through the first shunt resistor;
a first voltage measurer that measures voltage of each battery of the first assembled battery;
a first impedance measurement calculator that calculates AC impedance of each battery of the first assembled battery, based on a current value measured by the first current measurer and a voltage value of each battery of the first assembled battery measured by the first voltage measurer;
a second current measurer that measures current flowing through the second shunt resistor;
a second voltage measurer that measures voltage of each battery of the second assembled battery; and
a second impedance measurement calculator that calculates AC impedance of each battery of the second assembled battery, based on a current value measured by the second current measurer and a voltage value of each battery of the second assembled battery measured by the second voltage measurer.

8. The battery monitoring device according to claim 5 or 6, wherein
a most negative battery of the first assembled battery is connected to a most positive battery of the second assembled battery,
a positive terminal of a most positive battery of the first assembled battery is connected to the first shunt resistor,
the first shunt resistor is connected to a first transistor that is the first switch,
a negative terminal of a most negative battery of the second assembled battery is connected to the second shunt resistor, and
the second shunt resistor is connected to a second transistor that is the second switch.

9. The battery monitoring device according to claim 1, wherein
the plurality of batteries include one or more batteries included in both the first assembled battery and the second assembled battery.

10. The battery monitoring device according to any one of claims 1 to 6 and 9, wherein
a most negative battery of the first assembled battery is connected to a most positive battery of the second assembled battery, and
the battery monitoring device comprises:
a calculator that, based on AC impedance of the most negative battery of the first assembled battery and AC impedance of the most positive battery of the second assembled battery, performs at least one of determination as to whether the first measurement circuit and the second measurement circuit are malfunctioning or calibration of the AC impedance of each of the plurality of batteries measured.

11. The battery monitoring device according to any one of claims 1 to 6 and 9, comprising:
a first calculator that estimates a first state of health (SOH) of any first battery included in the first assembled battery, based on AC impedance of the first battery, and estimates a second SOH of any second battery included in the second assembled battery, based on AC impedance of the second battery; and
a second calculator that, based on the first SOH, the second SOH, a third SOH of the first battery, and a fourth SOH of the second battery, performs at least one of determination as to whether the first measurement circuit and the second measurement circuit are malfunctioning or calibration of the AC impedance of each of the plurality of batteries measured, the third SOH and the fourth SOH being estimated using a parameter other than AC impedance.

12. The battery monitoring device according to any one of claims 1 to 6 and 9, wherein
a most negative battery of the first assembled battery is connected to a most positive battery of the second assembled battery, and
the battery monitoring device comprises:
a temperature measurer that measures temperature of the most negative battery of the first assembled battery and temperature of the most positive battery of the second assembled battery, based on (i) output of a first temperature sensor for measuring the temperature of the most negative battery and (ii) output of a second temperature sensor for measuring the temperature of the most positive battery; and
a battery state estimator that, based on (i) internal temperature of the most negative battery of the first assembled battery estimated from AC impedance of the most negative battery and (ii) the temperature of the most positive battery and the temperature of the most negative battery measured by the temperature measurer, performs at least one of determination as to whether the first measurement circuit and the second measurement circuit are malfunctioning or calibration of the AC impedance of each of the plurality of batteries measured.

13. A battery monitoring method comprising:
generating a control signal for controlling a first measurement circuit connected to a first assembled battery and a second measurement circuit connected to a second assembled battery, the first assembled battery and the second assembled battery being obtained by dividing a plurality of batteries connected in series; and
calculating alternating current (AC) impedance of each of the plurality of batteries, based on (i) a first current value of current flowing through the first measurement circuit and a voltage value of each battery included in the first assembled battery and (ii) a second current value of current flowing through the second measurement circuit and a voltage value of each battery included in the second assembled battery, (i) the first current value and the voltage value and (ii) the second current value and the voltage value being measured at mutually different timings, wherein
the first measurement circuit includes a first switch connected in series with the first assembled battery,
the second measurement circuit includes a second switch connected in series with the second assembled battery, and
in the generating of the control signal, the control signal for turning on the first switch and the second switch in a mutually exclusive manner is generated.
